# EUROPÄISCHE PATENTSCHRIFT

(11) **EP 1 644 749 B1**
(45) Veröffentlichungstag und Bekanntmachung des Hinweises auf die Patenterteilung: **22.09.2010**
(21) Anmeldenummer: 04729081.2
(22) Anmeldetag: 23.04.2004
(51) Int. Cl.: G01R 31/36

(54) **FAHRZEUGBORDNETZSENSORVORRICHTUNG UND VERFAHREN ZUR HERSTELLUNG EINER SENSORVORRICHTUNG**
SENSOR UNIT FOR AN ON-BOARD NETWORK OF A MOTOR VEHICLE, AND METHOD FOR THE PRODUCTION OF A SENSOR UNIT
DISPOSITIF DE DETECTION DE RESEAU EMBARQUE ET PROCEDE POUR PRODUIRE UN DISPOSITIF DE DETECTION

(30) Priorität: 16.07.2003 DE 10332410
(43) Veröffentlichungstag der Anmeldung: 12.04.2006
(73) Patentinhaber: Auto-Kabel Managementgesellschaft mbH, 79688 Hausen i.W. (DE)
(72) Erfinder: LIETZ, Franz-Josef, 46049 Oberhausen (DE); GRONWALD, Frank, 50181 Bedburg (DE)
(74) Vertreter: Cohausz & Florack
(86) Internationale Anmeldenummer: PCT/EP2004/004316
(87) Internationale Veröffentlichungsnummer: WO 2005/008265

(56) Entgegenhaltungen:
- DE-A- 10 031 243
- DE-A- 10 118 027
- DE-A- 19 961 311
- DE-C- 10 001 345
- US-B1- 6 171 121
- US-B1- 6 218 805

## Beschreibung

Die Erfindung betrifft eine Kraftfahrzeugbordnetzsensorvorrichtung zur Erfassung von Strom, Spannung und/oder Temperatur innerhalb von Bordnetzen von Kraftfahrzeugen, mit zwei an stromführenden Leitungen innerhalb des Bordnetzes angeschlossenen Anschlussstücken und mit einem die Anschlussstücke elektrisch verbindenden Messwiderstand. Darüber hinaus betrifft die Erfindung ein Verfahren zur Herstellung eines solchen Kraftfahrzeugbordnetzsensors.

Der steigende Bedarf an elektrischer Leistung in Kraftfahrzeugen führt dazu, dass die Überwachung von Energieverteilung, Energiesteuerung notwendig und die Erfassung der Ladebilanz von Batterien, beispielsweise des Batteriestroms, der Batteriespannung und der Batterietemperatur erforderlich ist. Mit Hilfe eines integrierten Batteriesensors, welcher beispielsweise die Größen Strom, Spannung und Temperatur der Batterie erfasst, können diese Daten ermittelt und verarbeitet werden. Ein solcher Sensor wird vorzugsweise in Batterienähe angeordnet.

Aus der deutschen Offenlegungsschrift DE 199 61 311 A1 ist ein solcher Batteriesensor bekannt. Dieser Batteriesensor ist an einer Batterie-Messklemme angeordnet. Der Batteriesensor ist gebildet aus einem Leistungs-Präzisionswiderstand (Shunt) und einer Elektronikeinheit. Der Shunt und die Elektronikeinheit sind zwischen zwei Widerstandsanschlüssen angeordnet, wobei am ersten Widerstandsanschluss eine elektrische Verbindung mit dem Polschuh der Batterie gewährleistet ist und am zweiten Widerstandsanschluss eine Isolierung eine elektrische Verbindung mit dem Polschuh der Batterie verhindert. Am zweiten Widerstandsanschluss kann über eine Schraube und eine eingebettete Schraubenmutter der Kabelschuh eines gewöhnlichen Anschlusskabels angeschlossen werden. Die eingesetzten Shunts sind gemäß dieser Veröffentlichung aus dem Material Manganin, welches gegenüber Kupfer eine geringe Thermospannung besitzt, gebildet. Ferner besitzen die Shunts einen sehr kleinen Temperaturkoeffizienten, wodurch auch über ein breites Temperaturspektrum ein zuverlässiger Messwert erhalten werden kann.

Gemäß der DE 199 61 311 ist der Shunt unmittelbar an der Polschuhklemme der Batterie angeordnet. Die aufgrund der hohen Spitzen- und Dauerströme im Bordnetz von Kraftfahrzeugen auftretende Eigenerwärmung der Shunts wird gemäß der beschriebenen Vorrichtung dadurch thermisch abgeleitet, dass sie direkt an der Batterie angeordnet sind. Der Shunt selber ist rechteckig gebildet und weist daher ein geringes Flächenträgheitsmoment auf. Um ein nahezu störungsfreies Messergebnis erzielen zu können, sind jedoch von außen auf die Mess- und Auswerteelektronik einwirkende Kräfte zu vermeiden. Auch müssen Beschädigungen an der Elektronik durch diese Kräfte möglichst vermieden werden. Weist der Shunt kein verhältnismäßig großes Flächenträgheitsmoment auf, so kann es zu mechanischen Verformungen der Mess- und Auswerteelektroniken kommen. Dies kann zur Zerstörung der Elektronik oder Verfälschung der Messung führen.

Aus der DE 42 36 086 C1 ist ein weiterer Präzisionsmesswiderstand und ein Verfahren zur Herstellung eines solchen Widerstandes bekannt. Hierzu wird zwischen zwei Anschlussteilen aus Metall, die an einen Leiter angeschlossen sind, ein Widerstandselement eingeführt. Dieses Widerstandselement hat einen quaderförmigen Querschnitt. Das hat aber den Nachteil, dass zum einen die Bauform des Shunts groß ist und zum anderen die Integration des Shunts ins Bordnetz kompliziert ist.

Aus der US 6,218,805 B1 ist eine Batteriemessklemme mit einer Befestigungsmuffe bekannt, die fest mit dem positiven Pol eine wiederaufladbaren Batterie thermisch und elektrisch verbunden ist. Die Batteriemessklemme umfasst im Inneren Sensoren und Mittel zur Verarbeitung der Signale, die von den Sensoren erzeugt wurden, und zur Vorbereitung zur Weiterleitung über eine doppeladrige Datenleitung zu einer Anpass-Anzeigeeinrichtung. Zur Energieversorgung der Sensoren und diesen Mitteln ist die Batteriemessklemme ebenso mit dem negativen Polanschluss der Batterie über ein Batteriekabel verbunden.

Aus der DE 100 01 345 C1 (D2) ist eine Vorrichtung zur Ermittlung des Stromes an einem Energiespeicher, dessen Minuspol über eine Leitung mit der Masse verbunden ist, bekannt. Über den Pluspol ist der Energiespeicher sowohl mit einem Generator als auch mit elektrischen Verbrauchern verbunden. Die Leitung ist als ein hohles Messkabel ausgebildet, in dessen Hohlraum koaxial zu einem Kabelschuh verbindenden Kabelmantel eine Messleitung verläuft.

Die gemäß des Standes der Technik bekannten Messwiderstände haben eine große Bauform und ihre Integration in das Bordnetz gestaltet sich in der Regel aufwändig.

Aus den zuvor aufgezeigten Nachteilen ergibt sich die erfindungsgemäße Aufgabe, einen Messwiderstand zur Verfügung zu stellen, der eine kostengünstige Herstellung ermöglicht und leicht in ein Kraftfahrzeugbordnetz integrierbar ist.

Die zuvor hergeleitete Aufgabe wird erfindungsgemäß durch eine Kraftfahrzeugbordnetzsensorvorrichtung nach Anspruch 1 und ein Verfahren zur Herstellung eines Kraftfahrzeugbordnetzsensors nach Anspruch 20 gelöst. Wobei der Messwiderstand im Wesentlichen rotationssymmetrisch ist und zwischen den Anschlussstücken angeordnet ist. Durch die Rotationssymmetrie des Shunts wird eine signifikante Bauraumreduktion ermöglicht. Ferner ist die Integration eines solchen Shunts in die Bordelektrik einfach. Ein erfindungsgemäßer Shunt kann in sämtliche bestehende Leitungen leicht integriert werden. Ein erhöhter Integrationsaufwand, welcher beim planeren Aufbau eines Shunts entsteht, entfällt. Der Shunt lässt sich in bestehende Leitersysteme, insbesondere alle stromführenden Komponenten, leicht integrieren. Stromführende Komponenten können dabei Batterieklemmen, Kabelschuhe, Leitungen, Übergabestützpunkte, Sicherungsdosen und weitere sein. Neben der hervorragenden Eignung einer Verbindung mit rotationssymmetrischen Anschlussteilen, einer kleinen Bauform und geringen Gesamtkosten bei der Herstellung, liegt ein weiterer Vorteil der erfindungsgemäßen Vorrichtung darin, dass sie ein wesentlich höheres Flächenträgheitsmoment als ein planares Bauelement aufweist. Von außen einwirkende Kräfte, welche eine Verbiegung des Shunts hervorrufen könnten, können somit weitestgehend kompensiert werden. Eine Verbiegung der Vorrichtung kann im Wesentlichen verhindert werden. Somit wird zum einen die eventuell am Shunt angeordnete Auswerteelektronik nicht verbogen. Zum anderen wird eine Widerstandsänderung, die aufgrund einer Verbiegung hervorgerufen wird, stark reduziert. Dies führt zu verbesserten Messergebnissen.

Bevorzugt ist der Shunt koaxial mit den stromführenden Leitungen angeordnet. Dann ist die Integration besonders platzsparend.

Vorteilhafte Ausgestaltungen der Anschlussstücke und der Messwiderstände ergeben sich aus den Ansprüchen 3 bis 5.

Die Anschlussstücke sind mit den elektrischen Leitungen, zum Beispiel Batterieklemme oder Batterieleitung, mittels einer Intermetall- oder Diffusionsverbindung zu fügen. Dies kann beispielsweise mit Hilfe von Reibschweißen oder anderer für Leiterwerkstoffe verwendeter Materialien geschehen. Für kupferhaltige Werkstoffe ist auch Elektronenstrahlschweißen vorteilhaft.

Die Anordnung einer Auswerteelektronik auf Schlüsselflächen der Anschlussstücke ermöglicht das direkte Aufbringen der Elektronik auf den Widerstand. Somit entfallen die Anschlussleitungen einer Auswerteelektronik an den Messwiderstand. Es kann jedoch auch eine dezentrale Erfassung der Messsignale erfolgen. Hierbei werden die Messleitungen zu einer entfernten Messeinheit geführt. Schlüsselflächen der Anschlussstücke sind dann nicht mehr erforderlich.

Gemäß einer weiteren vorteilhaften erfinderischen Ausgestaltung wird vorgeschlagen, dass der Messwiderstand eine pyrotechnische Zündeinheit (Zündpille) zum Trennen zumindest eines Anschlussstücks vom Messwiderstand aufweist. Besonders vorteilhaft ist hierbei, wenn der Shunt in Rohrform ausgeprägt ist und innerhalb des Rohres die pyrotechnische Zündeinheit angeordnet ist. Im Fehlerfall, beispielsweise bei Kurzschlussströmen, die eine Stromschwelle oder eine Strom-Zeitkennlinie überschreiten, kann die pyrotechnische Einheit autark oder unter Mithilfe eines übergelagerten Steuergerätes ausgelöst werden. Das Auslösen der pyrotechnischen Zündeinheit bewirkt die Trennung zwischen Shunt und Anschlussstück.

Gemäß Anspruch 7 wird dabei bevorzugt, dass zumindest ein Anschlussstück über eine Loslagerung mit dem Messwiderstand elektrisch verbunden ist. Die Loslagerung des Anschlussstücks bewirkt, dass im Falle der Zündung der pyrotechnischen Zündeinheit gerade dieses Anschlussstück gelöst wird. Eine Wiederkontaktierung von Shunt und Anschlussstücke wird somit konstruktiv vermieden.

Eine direkte Verbindung des Shunts mit einer Batterieklemme ist gemäß Anspruch 8 bevorzugt. Somit kann der Shunt unmittelbar an der Batterie angeordnet werden.

Ein modularer Aufbau wird gemäß Anspruch 9 bevorzugt. Hierbei sind der Messwiderstand und die Auswerteelektronik als getrennte Baugruppen gebildet. Der Anschluss des Sensorelements, gebildet aus Messwiderstand und Anschlussstücken, in das Kraftfahrzeugbordnetz kann somit an einer bestehenden Batterieklemme erfolgen. An das Sensorelement kann die Auswerteelektronik angeschlossen werden. Der modulare Aufbau ermöglicht es, dass entsprechend der Ausstattungsmerkmale eines Kraftfahrzeugs entweder ein erfindungsgemäßes Sensorelement mit Auswerteelektronik an einer Batterieklemme vorgesehen ist oder weggelassen werden kann. Durch die Modularität kann dann anstelle des Sensorelements einfach ein entsprechendes Kabel an die Batteriemessklemme angeschlossen werden. Ein Austauschen des Sensorelements ist ebenfalls vereinfacht.

Um das Sensorelement, vorzugsweise den Messwiderstand oder einen anderen Sensor, und die Auswerteelektronik vor Spritzwasser oder sonstigen Umwelteinflüssen zu schützen wird vorgeschlagen, dass der Messwiderstand und/oder die Auswerteelektronik jeweils umspritzt ist. Das bedeutet, dass eine Umspritzung um den Messwiderstand oder das Sensorelement vorgesehen werden kann. Auch kann eine Umspritzung um die Auswerteelektronik vorgesehen werden. Das jeweils umspritzte Element ist vor Umwelteinflüssen geschützt. Die Umspritzung kann mit Hilfe von geeigneten Kunststoffen erfolgen. Aus der Umspritzung können Anschlussstifte herausgeführt werden, um den Messwiderstand und die Auswerteelektronik miteinander elektrisch zu kontaktieren. Fertigungstechnisch kann so in modularer Fertigung jeweils ein Messwiderstand erfindungsgemäß rotationssymmetrisch gefertigt werden und eine Auswerteelektronik getrennt davon und die jeweiligen einzelnen modularen Bauelemente können danach elektrisch miteinander kontaktiert werden.

Um Kriechströme über den Messwiderstand zu vermeiden, wird vorgeschlagen, den Messwiderstand passiv zu beschichten. Die passive Beschichtung kann in einer Lackierung des Messwiderstands mit einem elektrisch isolierenden Lack erfolgen. Jedoch ist jede andere Beschichtung des Messwiderstands mit Hilfe eines elektrisch isolierenden Substrats möglich.

Der modulare Aufbau des Messwiderstands an einer Batterieklemme wird ebenfalls dadurch bewirkt, dass ein Anschlussstück zur Aufnahme in oder an einer Batterieklemme gebildet ist. Hierzu kann das Anschlussstück so gebildet sein, dass es mit Hilfe eines Gewindes in eine entsprechende Bohrung der Batterieklemme geschraubt werden kann. Auch ist es möglich, dass das Anschlussstück als Pressbolzen in eine entsprechende Bohrung der Batterieklemme eingeführt werden kann. Ferner kann das Anschlussstück nach außen hin sich verjüngend geformt sein. Dann kann ebenfalls eine form- und kraftschlüssige Verbindung zwischen Anschlussstück und einer Bohrung der Batterieklemme vorgesehen werden. Schließlich ist es möglich, dass das Anschlussstück, in Richtung des Messwiderstandes gesehen, zunächst ein Außengewinde aufweist und dann übergeht in ein konisch sich verbreiterndes Element. Dies bewirkt, dass der Messwiderstand in ein Gewinde einer Batterieklemme geschraubt werden kann und ein guter elektrischer Kontakt zwischen Batterieklemme und Anschlussstück durch das konisch geformte Element bewirkt wird, da sich dieses beim Anschrauben in die Bohrung hineinzieht und somit ein guter Formschluss gewährleistet wird.

Auch ist es möglich, dass die Batterieklemme einen Anschlussstift aufweist, der in eine Bohrung des Anschlussstückes gesteckt werden kann. Dabei ist es möglich, dass dies mit Hilfe einer Presspassung erfolgt. Auch ist es möglich, dass das Anschlussstück in seiner Bohrung ein Innengewinde aufweist, in das der mit einem Außengewinde versehene Anschlussstift der Batterieklemme geschraubt werden kann. All diese Anordnungen ermöglichen den modularen Aufbau von Batterieklemme und Sensorvorrichtung.

Um die Auswerteelektronik mit dem Messwiderstand kontaktieren zu können, wird vorgeschlagen, dass das Sensorelement Anschlusselemente zum elektrischen Anschluss der Elektronik aufweist. Dies können Kontaktstifte an den Anschlussstücken sein. Die Anschlusselemente können aus einer Isolierung des Sensorelementes herausgeführt sein. Somit kann das Sensorelement getrennt von der Elektronik isoliert werden und dennoch mit dieser kontaktiert sein.

Besonders vorteilhaft ergibt sich eine elektrische Kontaktfläche, wenn die Umspritzung überfräst ist und wenn durch die Überfräsung eine elektrische Kontaktfläche an zumindest einem Anschlussstück gebildet ist. Die Überfräsung gewährleistet einerseits, dass Kontaktflächen an den Anschlussstücken freigelegt werden und andererseits eine Ebene zum guten elektrischen Kontaktieren der Auswerteelektronik mit dem Sensorelement.

Vorteilhaft, da modular, ist eine Kraftfahrzeugbordnetzsensorvorrichtung bei der zwischen Batterieklemme und Sensorelement ein Kabelstrang angeordnet ist.

Auch wird vorgeschlagen, dass die Auswerteelektronik an die Rotationssymmetrie des Messwiderstandes und/oder der Anschlussstücke angepasst geformt ist. Dieses Anschmiegen der Auswerteelektronik an die Form des Messwiderstandes bzw. der Anschlussstücke ermöglicht ein geringes Bauvolumen.

Um einen unmittelbaren Abgriff der Spannung am Messwiderstand zu ermöglichen, wird auch vorgeschlagen, dass auf dem Messwiderstand zumindest zwei wahlfreie Abgriffe zum Anschluss einer Auswerteelektronik vorgesehen sind, derart, dass eine Spannung über dem Messwiderstand zwischen den Abgriffen messbar ist. Die Abgriffe können in geeigneter Weise auf dem Messwiderstand angeordnet werden. Dieser wahlfreie Abgriff erlaubt eine Anordnung angepasst den Bauraum oder an Messvoraussetzungen.

Dadurch, dass die Abgriffe unmittelbar auf dem Messwiderstand angeordnet sind, wird eine hohe Messgenauigkeit erzielt. Auch kann somit eine gute Trennung zwischen Sensorelement und Auswertelektronik erzielt werden.

Um die Anordnung unmittelbar in das Leitungsnetz zu integrieren oder aber direkt an eine Batterieklemme anschließen zu können, wird auch vorgeschlagen, dass zumindest ein Anschlussstück als Teil des Messwiderstands gebildet ist und unmittelbar mit der stromführenden Leitung und/oder einer Batterieklemme formschlüssig und/oder kraftschlüssig verbunden ist. Hierbei kann der Messwiderstand aus Manganin gebildet sein, womit auch zumindest ein Anschlussstück aus Manganin ist. Das weitere Anschlussstück kann demgemäss auch aus Manganin sein oder beispielsweise aus Kupfer.

Ein weiterer Gegenstand der Erfindung ist ein Verfahren zur Herstellung eines Kraftfahrzeugbordnetzsensors. Hierbei wird vorgeschlagen, dass jeweils zwei Anschlussstücke an stromführenden Leitungen innerhalb des Bordnetzes stromschlüssig angebracht werden, und dass die Anschlussstücke untereinander mit Hilfe eines rotationssymmetrischen Messwiderstands stromschlüssig verbunden werden.

Bevorzugt ist dabei, dass der Messwiderstand mit einer pyrotechnischen Zündeinheit bestückt wird und dass im Fehlerfall die pyrotechnische Zündeinheit gezündet wird und somit zumindest ein Anschlussstück vom Messwiderstand getrennt wird.

Die Erfindung wird nachfolgend anhand einer ein Ausführungsbeispiel zeigenden Zeichnungen näher erläutert. In der Zeichnung zeigen:
- Fig. 1: einen Shunt und Anschlussstücke in Stangenform nebst Schnittzeichnung;
- Fig. 2: einen Shunt in Rohrform und Anschlussstücke in Stangenform nebst Schnittzeichnung;
- Fig. 3: einen Shunt und Anschlussstücke in Rohrform nebst Schnittzeichnung;
- Fig. 4: einen Shunt in Stangenform und Anschlussstücke in Rohrform:
- Fig. 5: eine erfindungsgemäße Vorrichtung an einer Batterieklemme;
- Fig. 6: einen Shunt mit pyrotechnischer Zündeinrichtung, zusammengebaut;
- Fig. 7: einen Shunt nach Trennung durch eine pyrotechnische Zündeinrichtung.

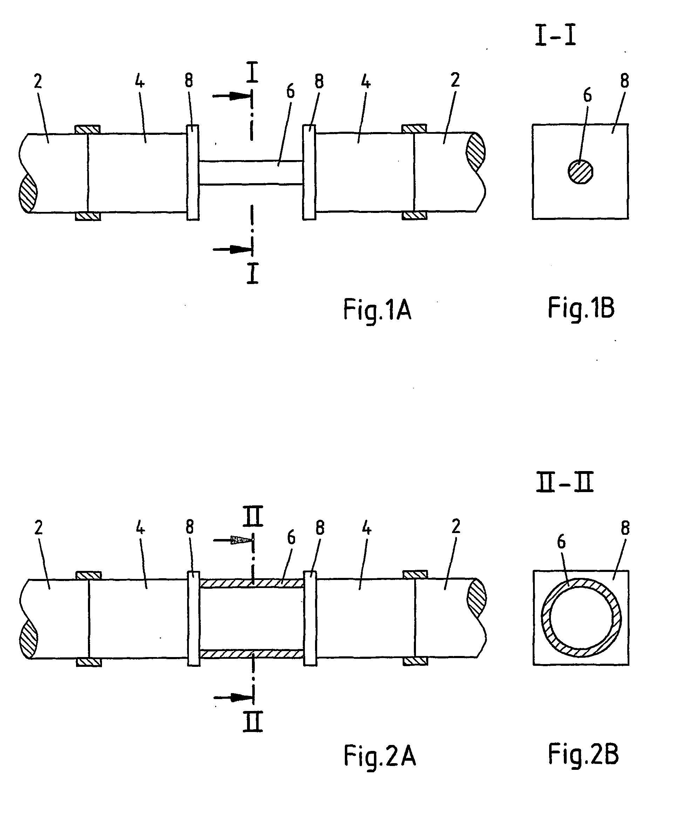

Fig. 1a zeigt zwei Leitungsenden 2, die elektrisch mit zwei Anschlussstücken 4 verbunden sind. Die Anschlussstücke 4 weisen Schlüsselflächen 8 auf und sind über einen Leistungs-Präzisionswiderstand (Shunt) 6 miteinander verbunden. Die Anschlussstücke 4 sind rotationssymmetrisch stabförmig. Die Schlüsselflächen 8 weisen einen quadratischen Querschnitt auf und der Shunt 6 zwischen den Anschlussstücken 4 ist rotationssymmetrisch stabförmig. Vorzugsweise ist der Shunt koaxial zu den Leitungen und/oder den Anschlussstücken. Dies kann für alle nachfolgenden Beispiele gelten.

Die Verbindung zwischen Leitungsenden 2 und Anschlussstücken 4 ist mit Hilfe von Schweißen oder Löten gewährleistet. Ferner kann eine kraftschlüssige, formschlüssige oder stoffschlüssige Verbindung vorgesehen sein. Es sollte nur ein guter elektrischer Leitwert zwischen Anschlussstück 4 und Leitung 2 gewährleistet sein.

Aus der Figur 1b ist zu erkennen, dass der Shunt 6 rotationssymmetrisch und koaxial zu den Anschlussstücken 4 angeordnet ist.

In Fig. 2a und den weiteren Figuren sind gleiche Elemente mit gleichen Bezugszeichen versehen. Fig. 2 zeigt eine Anordnung, bei der die Anschlussstücke 4 stabförmig sind und der Shunt 6 rohrförmig. Dies ist auch aus der Figur 2b zu erkennen. Dieser Shunt weist ein höheres Flächenträgheitsmoment bei gleichem Widerstand gegenüber dem in Fig. 1 dargestellten Shunt auf. Die elektrische Verbindung zwischen Leitung 2 und Anschlussstück 4 ist vorzugsweise eine intermetallische Verbindung oder eine Diffusionsverbindung. Die Verbindung zwischen Anschlussstück 4 und Shunt 6 ist ebenfalls vorzugsweise intermetallisch oder über eine Diffusionsverbindung gebildet.

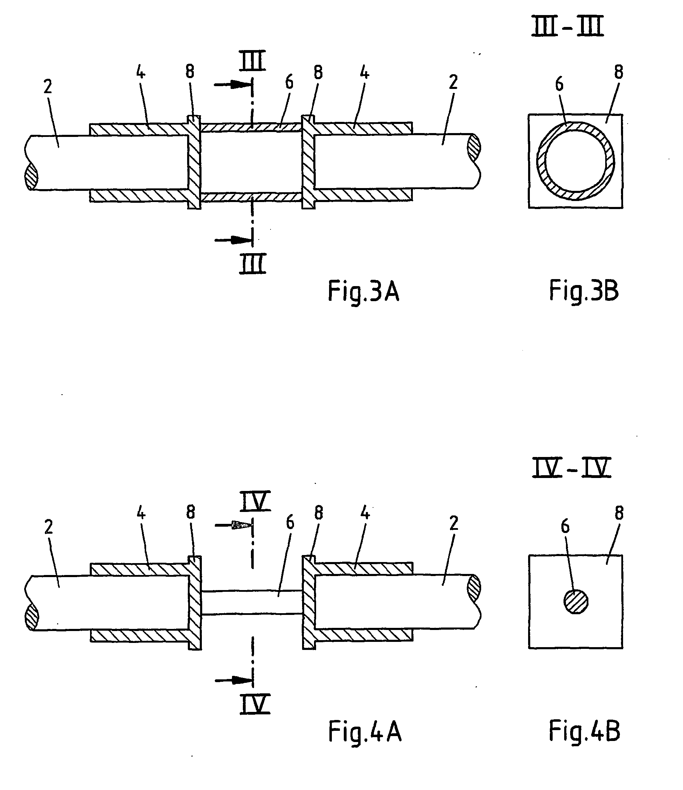

Fig. 3a zeigt eine weitere mögliche Gestaltung der Anschlussstücke 4. Die Anschlussstücke 4 sind gemäß Fig. 3 rohrförmig. Die Enden der Leitungen 2 können in die Öffnungen der Anschlussstücke 4 eingeführt und dort metallisch verbunden sein. Denkbar sind zum Beispiel auch Klemmverbindungen. Wie aus der Figur 3b zu erkennen ist, ist der Shunt 6 ebenfalls rohrförmig gebildet.

In der Fig. 4a ist eine Vorrichtung gezeigt, bei der die Anschlussstücke 4 rohrförmig sind und der Shunt 6 stangenförmig ist. Dies ist auch aus der Figur 4b erkennbar.

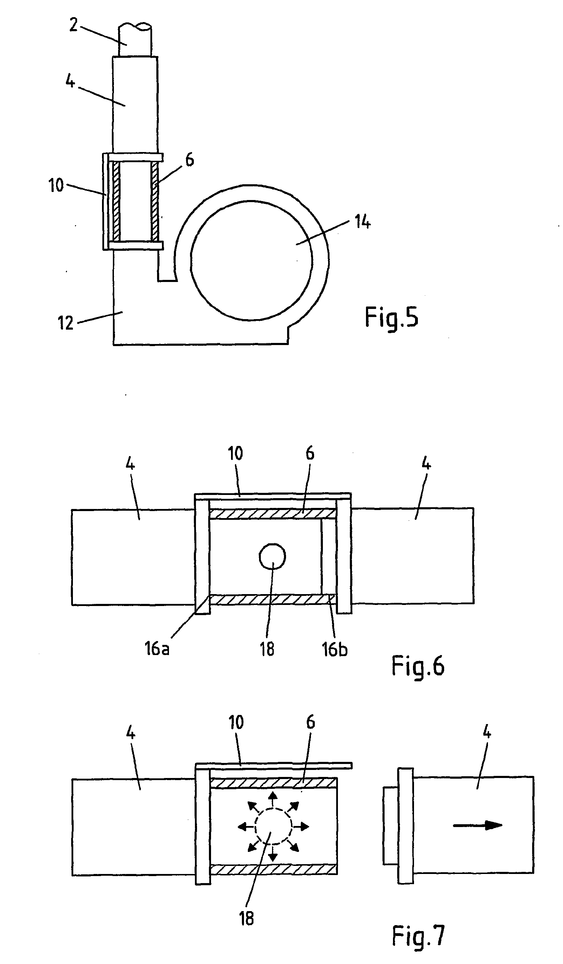

Da aufgrund der kleinen Bauform des Shunts kleinbauende Konstruktionen möglich sind, ist eine direkte Anordnung des Shunt an der Batterie gemäß Fig. 5 möglich. Der Polschuh 14 ist mit einer Batterieklemme 12 verbunden. Das eine Ende der Batterieklemme 12 bildet ein Anschlussstück 4. Der Anschluss der Batterie an die Bordelektronik wird über ein weiteres Anschlussstück 4 und ein daran angeschlossenes Kabel 2 ermöglicht. Dazwischen angeordnet ist ein Shunt 6 mit einer Auswerteelektronik 10. Die Auswerteelektronik 10 wertet die am Shunt gemessenen elektrischen Messwerte aus. Durch die rotationssymmetrische Anordnung des Shunts wird ein hohes Flächenträgheitsmoment gewährleistet, wodurch eine Verbiegung des Shunts 6 oder der Auswerteelektronik 10 zumindest weitestgehend vermieden wird. Dadurch werden die Messergebnisse wenig verfälscht.

Fig. 6 zeigt einen Shunt mit einer integrierten pyrotechnischen Zündeinheit 18. Der Shunt 6 ist auf der einen Seite mit einem Anschlussstück 4 über eine feste Verbindung 16a verbunden. Diese feste Verbindung 16a ist elektrisch leitend und stoffschlüssig. Das zweite Anschlussstück 4 ist mit dem Shunt 6 über ein Loslager 16b verbunden. Das Loslager 16b weist eine geringere Verbindungsfestigkeit als die feste Verbindung 16a auf. Auch das Loslager 16b stellt eine stoffschlüssige und elektrisch leitende Verbindung zwischen Anschlussstück 4 und Shunt 6 dar. Eine Auswerteelektronik 10 ist an den Anschlussstücken 4 angeordnet. Eine Verbindung zwischen der Auswerteelektronik 10 und dem Shunt 6 ist nicht dargestellt. Die pyrotechnische Zündeinheit 18 kann autark in Abhängigkeit eines Kurzschlussstroms oder eines Spitzenstroms ausgelöst werden. Auch kann die pyrotechnische Zündeinrichtung 18 durch die Auswerteelektronik 10 beim Vorliegen eines Fehlerfalles, der in der Auswerteelektronik 10 ermittelt wird, ausgelöst werden. Die Auslösung der pyrotechnischen Zündeinheit 18 bewirkt eine Trennung von Anschlussstück 4 und Shunt 6, wie in Fig. 7 dargestellt ist.

In Fig. 7 ist zu erkennen, dass beim Auslösen der pyrotechnischen Zündeinheit 18 die Loslagerung 16b bewirkt, dass das Anschlussstück 4 vom Shunt 6 weggesprengt wird. Die elektrische Verbindung wird unterbrochen. Im Fehlerfall bedeutet dies eine erhöhte Sicherheit.

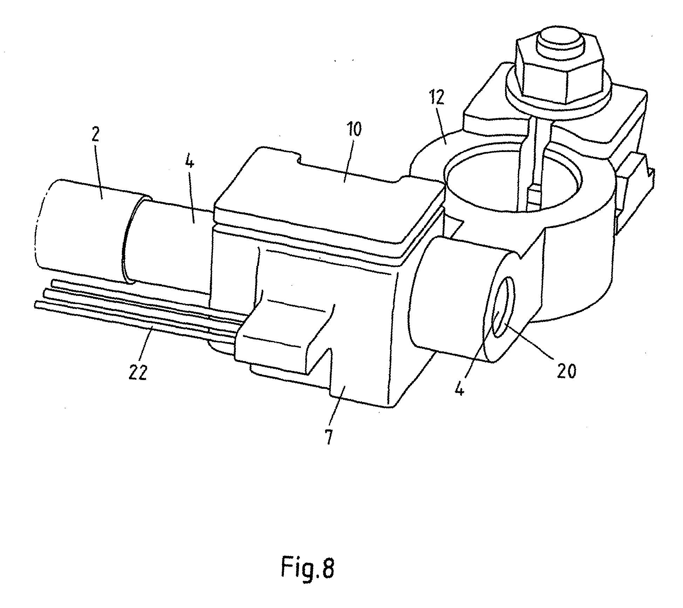

Fig. 8 zeigt eine erfindungsgemäße Sensorvorrichtung angeordnet an einer Anschlussklemme für eine Fahrzeugbatterie. Gezeigt ist eine Anschlussklemme 12 mit einem eine Bohrung 20 aufweisenden Anschlussterminal zum Anschluss eines Sensorelements 7. Das Sensorelement 7 ist gebildet aus den Anschlussstücken 4 und dem Messwiderstand 6, der durch die Umspritzung nicht zu erkennen ist. Aus dem Sensorelement 7 sind Leitungen 22 herausgeführt, um eine externe Auswertung der aufgenommenen Werte zu gewährleisten. Eine weitere Auswertung wird durch eine Auswerteelektronik 10 gewährleistet.

Wie zu erkennen ist, weist die Batterieklemme 12 an ihrem Anschlussterminal eine Bohrung 20 auf. Diese Bohrung ist so gebildet, dass ein Anschlussstück 4 eingesteckt werden kann. Die Verbindung zwischen Batterieklemme 12 und Anschlussstück 4 kann mit Hilfe eines Presssitzes oder einer Verschraubung ermöglicht werden. Andere Verbindungstechniken sind ebenfalls möglich. Durch den Übergang zwischen Batterieklemme 12 und Anschlussstück 4. wird ein Materialwechsel erzeugt. Die Batterieklemme 12 ist vorzugsweise aus Messing gebildet, wohingegen das Anschlussstück 4 vorzugsweise aus Kupfer geformt ist.

Das Anschlussstück 4 geht über in die Umspritzung, die Teile des Anschlussstücks 4 und den nicht gezeigten Messwiderstand 6 umwandelt und das Sensorelement 7 bildet. Auf der anderen Seite des Sensorelements 7 wird ein weiteres Anschlussstück 4 herausgeführt, an das ein Kabel 2 angeschlossen ist.

Neben dem umspritzten Messwiderstand ist die Auswerteelektronik 10 ebenfalls umspritzt. Über Kontaktstifte ist eine Kontaktierung zwischen den Anschlussstücken und der Auswerteelektronik möglich. Neben dem Messwiderstand können im oder am Sensorelement 7 weitere Sensoren vorgesehen sein. Die Messergebnisse lassen sich über die Kabel 22 abgreifen.

Der gezeigte Aufbau ist modular. Die Batteriemessklemme 12 stellt ein erstes Bauelement dar. Das Sensorelement 7 stellt ein zweites Bauelement dar. Die Auswerteelektronik 10 ist getrennt davon und ist ein drittes Bauelement. Diese drei Bauelemente können getrennt voneinander gefertigt und danach zusammengefügt werden.

Mit Hilfe der erfindungsgemäßen Kraftfahrzeugbordnetzsensorvorrichtung ist eine unkomplizierte, kleinbauende Integration eines Stromsensors in bestehende Bordnetze möglich. Die Sicherheit kann durch Verwendung von pyrotechnischen Zündpillen vergrößert werden.

## Patentansprüche

1. Kraftfahrzeugbordnetzsensorvorrichtung zur Erfassung von Strom, Spannung und/oder Temperatur innerhalb von Bordnetzen von Kraftfahrzeugen, mit zwei an stromführenden Leitungen (2) innerhalb des Bordnetzes angeschlossenen Anschlussstücken (4) und mit einem die Anschlussstücke (4) elektrisch verbindenden Messwiderstand (6), wobei zumindest ein Anschlussstück (4) eine eine Auswertelektronik (10) aufnehmende Schlüsselfläche (8) aufweist, und die Längsachse des Messwiderstands (6) zwischen den Anschlusstücken (4) parallel zum Stromfluss angeordnet ist,
**dadurch gekennzeichnet,**
**dass** der Messwiderstand (6) im Wesentlichen rotationssymetrisch ist und zwischen den Anschlussstücken (4) angeordnet ist.

2. Kraftfahrzeugbordnetz nach Anspruch 1, **dadurch gekennzeichnet, dass** der Messwiderstand (6) im Wesentlichen koaxial mit den stromführenden Leitungen (2) angeordnet ist.

3. Kraftfahrzeugbordnetzsensorvorrichtung nach Anspruch 1, **dadurch gekennzeichnet, dass** der Messwiderstand (6) und zumindest ein Anschlussstück (4) zylindrisch sind.

4. Kraftfahrzeugbordnetzsensorvorrichtung nach Anspruch 3, **dadurch gekennzeichnet, dass** der Messwiderstand (6) und/oder zumindest ein Anschlussstück (4) stabförmig sind.

5. Kraftfahrzeugbordnetzsensorvorrichtung nach Anspruch 3, **dadurch gekennzeichnet, dass** der Messwiderstand (6) und/oder zumindest ein Anschlussstück (4) röhrenförmig sind.

6. Kraftfahrzeugbordnetzsensorvorrichtung nach einem der Ansprüche 1 bis 5, **dadurch gekennzeichnet, dass** der Messwiderstand (6) eine pyrotechnische Zündeinheit (18) zum Trennen zumindest eines Anschlussstücks (4) vom Messwiderstand (6) aufweist.

7. Kraftfahrzeugbordnetzsensorvorrichtung nach Anspruch 6, **dadurch gekennzeichnet, dass** eine Loslagerung (16b) zumindest ein Anschlussstück (4) mit dem Messwiderstand (6) elektrisch verbindet.

8. Kraftfahrzeugbordnetzsensorvorrichtung nach einem der Ansprüche 1 bis 7, **dadurch gekennzeichnet, dass** ein Anschlussstück (4) als Teil einer Batterieklemme (12) gebildet ist.

9. Kraftfahrzeugbordnetzsensorvorrichtung nach einem der Ansprüche 1 bis 8, **dadurch gekennzeichnet, dass** der Messwiderstand (6) mit den Anschlussstücken (4) als Sensorelement zusammengefasst und eine Auswerteelektronik (10) als getrennte Baugruppen gebildet sind.

10. Kraftfahrzeugbordnetzsensorvorrichtung nach Anspruch 9, **dadurch gekennzeichnet, dass** das Sensorelement und/oder die Auswerteelektronik (10) jeweils umspritzt ist.

11. Kraftfahrzeugbordnetzsensorvorrichtung nach Anspruch 9, **dadurch gekennzeichnet, dass** das Sensorelement passiv beschichtet ist.

12. Kraftfahrzeugbordnetzsensorvorrichtung nach einem der Ansprüche 1 bis 11, **dadurch gekennzeichnet, dass** ein Anschlussstück (4) zur Aufnahme in oder an einer Batterieklemme gebildet ist.

13. Kraftfahrzeugbordnetzsensorvorrichtung nach Anspruch 9, **dadurch gekennzeichnet, dass** das Sensorelement Anschlusselemente zum elektrischen Anschluss der Elektronik aufweist.

14. Kraftfahrzeugbordnetzsensorvorrichtung nach Anspruch 10, **dadurch gekennzeichnet, dass** die Umspritzung überfräst ist und dass durch die Überfräsung eine elektrische Kontaktfläche an zumindest einem Anschlussstück gebildet ist.

15. Kraftfahrzeugbordnetzsensorvorrichtung nach Anspruch 9, **dadurch gekennzeichnet, dass** zwischen Batterieklemme und Sensorelement ein Kabelstrang angeordnet ist.

16. Kraftfahrzeugbordnetzsensorvorrichtung nach einem der Ansprüche 1 bis 15, **dadurch gekennzeichnet, dass** die Auswerteelektronik (10) an die Rotationssymmetrie des Messwiderstandes angepasst geformt ist.

17. Kraftfahrzeugbordnetzsensorvorrichtung nach einem der Ansprüche 1 bis 16, **dadurch gekennzeichnet, dass** auf dem Messwiderstand (6) zumindest zwei wahlfreie Abgriffe zum Anschluss einer Auswerteelektronik vorgesehen sind, derart, dass eine Spannung über dem Messwiderstand zwischen den Abgriffen messbar ist.

18. Kraftfahrzeugbordnetzsensorvorrichtung nach der Anspruch 17, **dadurch gekennzeichnet, dass** die Abgriffe unmittelbar auf dem Messwiderstand (6) angeordnet sind.

19. Kraftfahrzeugbordnetzsensorvorrichtung nach einem der Ansprüche 1 bis 18, **dadurch gekennzeichnet, dass** zumindest ein Anschlussstück (4) als Teil des Messwiderstands (6) gebildet ist und unmittelbar mit der stromführenden Leitung (2) und/oder einer Batterieklemme formschlüssig und/oder kraftschlüssig verbunden ist.

20. Verfahren zur Herstellung eines Kraftfahrzeugbordnetzsensor nach einem der Ansprüche 1 bis 19 bei dem jeweils zwei Anschlussstücke an stromführende Leitungen innerhalb des Bordnetzes stromschlüssig angebracht werden, bei dem eine Schlüsselfläche zumindest eines Anschlussstücks eine Auswertelektronik aufnimmt, und bei dem die Anschlussstücke untereinander mit Hilfe eines rotationssymmetrischen Messwiderstands stromschlüssig verbunden werden, derart, dass die Längsachsen des Messwiderstandes zwischen den Anschlussstücken parallel zum Stromfluss verläuft.

21. Verfahren nach Anspruch 20, **dadurch gekennzeichnet, dass** der Messwiderstand mit einer pyrotechnischen Zündeinheit bestückt wird und dass im Fehlerfall die pyrotechnische Zündeinheit gezündet wird und somit zumindest ein Anschlussstück vom Messwiderstand getrennt wird.

## Claims

1. Motor vehicle power supply system sensor device for measuring current, voltage and/or temperature within power supply systems of motor vehicles, having two connecting parts (4) connected to current-carrying cables (2) within the power supply system and having a shunt (6) electrically connecting the connecting parts (4), wherein at least one connecting part (4) has a key surface (8) accommodating an evaluation electronics unit (10) and the longitudinal axis of the shunt (6) is arranged between the connecting parts (4) parallel to the current flow, **characterised in that** the shunt (6) is essentially rotationally symmetrical and is arranged between the connecting parts (4).

2. Motor vehicle power supply system according to Claim 1, **characterised in that** the shunt (6) is essentially arranged coaxially with the current-carrying cables (2).

3. Motor vehicle power supply system sensor device according to Claim 1, **characterised in that** the shunt (6) and at least one connecting part (4) are cylindrical.

4. Motor vehicle power supply system sensor device according to Claim 3, **characterised in that** the shunt (6) and/or at least one connecting part (4) is/are rod-shaped.

5. Motor vehicle power supply system sensor device according to Claim 3, **characterised in that** the shunt (6) and/or at least one connecting part (4) is/are tubular.

6. Motor vehicle power supply system sensor device according to any one of Claims 1 to 5, **characterised in that** the shunt (6) has a pyrotechnic ignition unit (18) to separate at least one connecting part (4) from the shunt (6).

7. Motor vehicle power supply system sensor device according to Claim 6, **characterised in that** a movable bearing (16b) electrically connects at least one connecting part (4) to the shunt (6).

8. Motor vehicle power supply system sensor device according to any one of Claims 1 to 7, **characterised in that** one connecting part (4) is formed as part of a battery terminal (12).

9. Motor vehicle power supply system sensor device according to any one of Claims 1 to 8, **characterised in that** the shunt (6) is formed combined with the connecting parts (4) as a sensor element and an evaluation electronics unit (10) is formed as separate components.

10. Motor vehicle power supply system sensor device according to Claim 9, **characterised in that** the sensor element and/or the evaluation electronics unit (10) us/are respectively overmolded.

11. Motor vehicle power supply system sensor device according to Claim 9, **characterised in that** the sensor element is provided with a passive coating.

12. Motor vehicle power supply system sensor device according to any one of Claims 1 to 11, **characterised in that** a connecting part (4) is formed for reception in or on a battery terminal.

13. Motor vehicle power supply system sensor device according to Claim 9, **characterised in that** the sensor element has connecting elements for electrically connecting the electronics.

14. Motor vehicle power supply system sensor device according to Claim 10, **characterised in that** the overmold is milled, and **in that** an electrical contact surface is formed at at least one connecting part by means of the milling.

15. Motor vehicle power supply system sensor device according to Claim 9, **characterised in that** a cable harness is arranged between battery terminal and sensor element.

16. Motor vehicle power supply system sensor device according to any one of Claims 1 to 15, **characterised in that** the evaluation electronics unit (10) is formed so that it is adapted to the rotational symmetry of the shunt.

17. Motor vehicle power supply system sensor device according to any one of Claims 1 to 16, **characterised in that** at least two optional taps are provided on the shunt (6) for connecting an evaluation electronics unit in such a way that a voltage across the shunt can be measured between the taps.

18. Motor vehicle power supply system sensor device according to Claim 17, **characterised in that** the taps are arranged directly on the shunt (6).

19. Motor vehicle power supply system sensor device according to any one of Claims 1 to 18, **characterised in that** at least one connecting part (4) is formed as part of the shunt (6) and is positively and/or non-positively directly connected to the current-carrying cable (2) and/or a battery terminal.

20. Method for producing a motor vehicle power supply system sensor according to any one of Claims 1 to 19, in which two connecting parts are attached to current-carrying cables within the power supply system respectively, in which a key surface of at least one connecting part accommodates an evaluation electronics unit and in which the connecting parts are electrically interconnected with the aid of a rotationally symmetrical shunt in such a way that the longitudinal axes of the shunt run between the connecting parts parallel to the current flow.

21. Method according to Claim 20, **characterised in that** the shunt is equipped with a pyrotechnic ignition unit, and **in that** the pyrotechnic ignition unit is ignited in the event of a fault and consequently at least one connecting part is separated from the shunt.

## Revendications

1. Dispositif de détection de réseau embarqué de véhicule automobile pour la détermination du courant, de la tension et / ou de la température à l`intérieur de réseaux embarqués de véhicules automobiles, avec deux pièces de raccordement (4), raccordées à des conducteurs de courant (2), à l'intérieur du réseau embarqué, et avec une résistance de mesure (6), qui relie électriquement les pièces de raccordement (4), au moins l'une des pièces de raccordement (4) présentant une surface-clé (8), qui accueille un système d'évaluation électronique (10), et l'axe longitudinal de la résistance de mesure (6) étant disposé entre les pièces de raccordement (4), parallèlement au flux de courant, **caractérisé en ce que** la résistance de mesure (6) est essentiellement symétrique en rotation et est disposée entre les pièces de raccordement (4).

2. Dispositif de détection de réseau embarqué de véhicule automobile selon la revendication 1, **caractérisé en ce que** la résistance de mesure (6) est essentiellement disposée coaxialement avec les conducteurs de courant (2).

3. Dispositif de détection de réseau embarqué de véhicule automobile selon la revendication 1, **caractérisé en ce que** la résistance de mesure (6) et au moins une pièce de raccordement (4) sont cylindriques.

4. Dispositif de détection de réseau embarqué de véhicule automobile selon la revendication 3, **caractérisé en ce que** la résistance de mesure (6) et / ou au moins une pièce de raccordement (4) sont en forme de barres.

5. Dispositif de détection de réseau embarqué de véhicule automobile selon la revendication 3, **caractérisé en ce que** la résistance de mesure (6) et / ou au moins une pièce de raccordement (4) sont en forme de tubes.

6. Dispositif de détection de réseau embarqué de véhicule automobile selon l'une des revendications 1 à 5, **caractérisé en ce que** la résistance de mesure (6) présente une unité d'allumage pyrotechnique (18) pour séparer au moins une pièce de raccordement (4) de la résistance de mesure (6).

7. Dispositif de détection de réseau embarqué de véhicule automobile selon l'une des revendications 1 à 6, **caractérisé en ce qu'**un palier libre (16b) relie électriquement au moins une pièce de raccordement (4) à la résistance de mesure (6).

8. Dispositif de détection de réseau embarqué de véhicule automobile selon l'une des revendications 1 à 7, **caractérisé en ce qu'**une pièce de raccordement (4) est réalisée en tant que borne de batterie (12).

9. Dispositif de détection de réseau embarqué de véhicule automobile selon l'une des revendications 1 à 8, **caractérisé en ce que** la résistance de mesure (6), groupée avec les pièces de raccordement (4) sous la forme d'un élément de détection, et le système d'évaluation électronique (10) sont réalisés en tant que sous-groupes séparés.

10. Dispositif de détection de réseau embarqué de véhicule automobile selon la revendication 9, **caractérisé en ce que** l'élément de détection et / ou le système d'évaluation électronique (10) sont respectivement revêtus par extrusion.

11. Dispositif de détection de réseau embarqué de véhicule automobile selon la revendication 9, **caractérisé en ce que** l'élément de détection est revêtu passivement.

12. Dispositif de détection de réseau embarqué de véhicule automobile selon l'une des revendications 1 à 11, **caractérisé en ce qu'**une pièce de raccordement (4) est conçue pour être installée dans ou sur une borne de batterie.

13. Dispositif de détection de réseau embarqué de véhicule automobile selon la revendication 9, **caractérisé en ce que** l'élément de détection présente des éléments de raccordement pour la connexion électrique du système électronique.

14. Dispositif de détection de réseau embarqué de véhicule automobile selon la revendication 10, **caractérisé en ce que** le revêtement par extrusion est fraisé et que, par le fraisage, une surface de contact électrique est formée sur au moins une pièce de raccordement.

15. Dispositif de détection de réseau embarqué de véhicule automobile selon la revendication 9, **caractérisé en ce qu'**un faisceau de câbles est disposé entre la borne de batterie et l'élément de détection.

16. Dispositif de détection de réseau embarqué de véhicule automobile selon l'une des revendications 1 à 15, **caractérisé en ce que** le système d'évaluation électronique (10) est réalisé en adaptation à la symétrie en rotation de la résistance de mesure.

17. Dispositif de détection de réseau embarqué de véhicule automobile selon l'une des revendications 1 à 16, **caractérisé en ce que**, sur la résistance de mesure (6), sont prévus au moins deux prises optionnelles pour le raccordement d'un système d'évaluation électronique, de sorte que la tension puisse être mesurée entre les prises, par l'intermédiaire de la résistance de mesure.

18. Dispositif de détection de réseau embarqué de véhicule automobile selon la revendication 17, **caractérisé en ce que** les prises sont disposées directement sur la résistance de mesure (6).

19. Dispositif de détection de réseau embarqué de véhicule automobile selon l'une des revendications 1 à 18, **caractérisé en ce qu'**au moins une pièce de raccordement (4) est formée en tant que pièce faisant partie de la résistance de mesure (6) et est reliée par emboîtement et / ou par adhérence au conducteur de courant (2) et / ou à une borne de batterie.

20. Procédé de fabrication d'un dispositif de détection de réseau embarqué de véhicule automobile selon l'une des revendications 1 à 19, dans lequel deux pièces de raccordement sont agencées, à condition de courant, sur chacun des conducteurs de courant à l'intérieur du réseau embarqué, dans lequel une surface-clé d'au moins une pièce de raccordement accueille un système électronique d'évaluation, et dans lequel les pièces de raccordement peuvent être reliées entre elles, à condition de courant, au moyen d'une résistance de mesure symétrique en rotation, de sorte que les axes longitudinaux de la résistance de mesure s'étendent entre les pièces de raccordement, parallèlement au flux de courant.

21. Procédé selon la revendication 20, **caractérisé en ce que** la résistance de mesure est équipée d'une unité d'allumage pyrotechnique et que ladite unité d'allumage pyrotechnique est déclenchée en cas de défaut, et qu'au moins une pièce de raccordement est ainsi séparée de la résistance de mesure.
